(19) **Europäisches Patentamt**
**European Patent Office**
**Office européen des brevets**

(11) **EP 1 421 400 B1**

(12) **EUROPÄISCHE PATENTSCHRIFT**

(45) Veröffentlichungstag und Bekanntmachung des Hinweises auf die Patenterteilung:
**15.10.2008 Patentblatt 2008/42**

(21) Anmeldenummer: **02718110.6**

(22) Anmeldetag: **08.02.2002**

(51) Int Cl.:
***G01R 35/00*** (2006.01)

(86) Internationale Anmeldenummer:
**PCT/EP2002/001321**

(87) Internationale Veröffentlichungsnummer:
**WO 2002/065150 (22.08.2002 Gazette 2002/34)**

(54) **VERFAHREN ZUR FEHLERKORREKTUR DURCH DE-EMBEDDING VON STREUPARAMETERN, NETZWERKANALYSATOR UND SCHALTMODUL**

METHOD FOR CORRECTING ERRORS BY DE-EMBEDDING DISPERSION PARAMETERS, NETWORK ANALYST AND SWITCHING MODULE

PROCEDE POUR CORRIGER DES ERREURS PAR RETRAIT D'ENROBAGE DE PARAMETRES DE DISPERSION, ANALYSEUR DE RESEAU ET MODULE DE COMMUTATION

(84) Benannte Vertragsstaaten:
**DE FR GB**

(30) Priorität: **10.02.2001 DE 10106254**

(43) Veröffentlichungstag der Anmeldung:
**26.05.2004 Patentblatt 2004/22**

(73) Patentinhaber: **Rohde & Schwarz GmbH & Co. KG 81671 München (DE)**

(72) Erfinder:
• **FABRY, Hans-Joachim 12167 Berlin (DE)**
• **HEUERMANN, Holger 82629 Weyarn (DE)**

(74) Vertreter: **Körfer, Thomas et al Mitscherlich & Partner Patent- und Rechtsanwälte Postfach 33 06 09 80066 München (DE)**

(56) Entgegenhaltungen:
EP-A- 0 430 475          DE-A- 3 814 852
DE-A- 4 405 211          US-A- 5 578 932

**EP 1 421 400 B1**

**Beschreibung**

Die Erfindung betrifft ein Verfahren zur Fehlerkorrektur durch De-embedding von mit einem n Meßtore umfassenden, vektoriellen Netzwerkanalysators gemessenen Streuparameter eines mit den Meßtoren verbundenen Meßobjektes.

In der Hochfrequenztechnik wird das Verhalten von Schaltungen üblicherweise über Streuparameter beschrieben. Die Streuparameter stellen komplexe Reflexions- und Transmissionsparameter einer Schaltung dar und verknüpfen ein- und auslaufende Wellengrößen miteinander. Eine solche Darstellung mit komplexen Reflexions- und Transmissionsparametern ist den physikalischen Gegebenheiten der Problemstellungen der Hochfrequenztechnik besonders gut angepaßt.

So kann beispielsweise eine Schaltung, die ein lineares Zweitor bildet, durch seine Streumatrix [S], in der die Streuparameter zusammengefaßt sind, vollständig beschrieben werden. Werden die Wellen, die auf jeweils ein Meßtor des Zweitors zulaufen, mit $a_1$ und $a_2$ und die Wellen, die aus jeweils einem Meßtor des Zweitors herauslaufen, sich also in umgekehrter Richtung fortpflanzen, mit $b_1$ und $b_2$ bezeichnet, dann gilt für die Streumatrix [S] die Beziehung:

$$\begin{pmatrix} b_1 \\ b_2 \end{pmatrix} = \underbrace{\begin{pmatrix} S_{11} & S_{12} \\ S_{21} & S_{22} \end{pmatrix}}_{= [S]} \begin{pmatrix} a_1 \\ a_2 \end{pmatrix}$$

Es ist aus der Praxis bekannt, zur Bestimmung der Streuparameter einer Schaltung Netzwerkanalysatoren (NWA) einzusetzen, an die die Schaltung als zu vermessendes Meßobjekt angeschlossen wird. Über einen solchen Netzwerkanalysator werden auf das Meßobjekt zulaufende Wellen eingespeist und an Meßstellen erfaßt. Ebenso werden die sich in entgegengesetzte Richtung ergebenden Wellen an Meßstellen erfaßt. Aus den Meßwerten läßt sich dann die Streumatrix [S] bestimmen.

Ziel jeder n-Tor Messung mittels eines Netzwerkanalysators ist es, die Streuparameter möglichst präzise zu bestimmen. Allerdings treten durch die Netzwerkanalysatoren selber Fehler auf, wie beispielsweise Verkopplungen oder Fehlanpassungen, die die Meßergebnisse verfälschen.

Die Meßgenauigkeit von NWAs kann in der Regel mittels einer Systemfehlerkorrektur erheblich verbessert werden. Bei der Systemfehlerkorrektur werden innerhalb eines Kalibriervorgangs sogenannte Kalibrierstandards, d.h. Meßobjekte, die teilweise oder ganz bekannt sind, vermessen. Aus diesen Meßwerten gewinnt man dann über spezielle Rechenverfahren Korrekturdaten. Mit diesen Korrekturdaten und einer entsprechenden Korrekturrechnung erhält man für jedes beliebige Meßobjekt aus den Rohmeßwerten korrigierte Streuparameter, die von Systemfehlern des Netzwerkanalysators befreit sind.

Von De-embedding spricht man, wenn man die nach einer solchen Kalibrierung erhaltenen und noch nicht ausreichend fehlerbereinigten Streuparameter einer zweiten Meßwertkorrektur unterzieht. Diese kann im einfachsten Fall eine Multiplikation mit der inversen Kettenmatrix einer bekannten zwischen NWA und Meßobjekt geschalteten Leitung sein. In der Regel ist eine gute Kalibrierung in den Referenzebenen des Meßobjektes genauer als ein zusätzlicher De-embedding Schritt, zum Teil jedoch zu zeitaufwendig oder umständlich, und oft ist die Genauigkeit eines De-embedding Schritts ausreichend. In der Literatur wird De-embedding auch als "Two-Tier-Calibration" bezeichnet, was auch verdeutlicht, daß es sich beim De-embedding um eine zweistufige Kalibrierung bzw. Fehlerkorrektur der Rohmeßwerte handelt.

Mittels Netzwerkanalysatoren wurden zunächst lediglich Ein- und Zweitorparameter von elektronischen Halbleiterbauelementen bis hin zu Antennen vermessen. Diese Ein- und Zweitor-Kalibrierverfahren bilden jedoch keine hinreichend genaue Grundlage für eine Fehlerkorrektur bei der Vermessung von Mehrtorobjekten. Ein Problem bei Mehrtor-Messungen besteht nämlich darin, daß alle Tore des Meßobjektes miteinander verkoppelt sind. Man erhält somit nicht mehr an einer Meßstelle ein Maß für die hinlaufende, an der nächsten Meßstelle ein Maß für die reflektierte und letztlich an einer dritten Meßstelle ein Maß für eine transmittierte Welle, das von den Abschlüssen des Mehrtores unabhängig ist.

Seit einigen Jahren lassen sich Netzwerkanalysatoren aber mit einer nahezu beliebig großen Anzahl n an Meßtoren für die Detektion der komplexen Reflexions- und Transmissionseigenschaften von Mehrtorobjekten einsetzen. Verfahren hierzu werden beispielsweise in den Druckschriften DE 199 18 697 A1 und DE 199 18 960 A1 beschrieben. Die DE 199 18 960 A1 basiert dabei auf für Zweitor-Messungen eingesetzten 7-Term-Verfahren und die DE 199 18 697 A1 auf für Zweitor-Messungen eingesetzten 10-Term-Verfahren. Die in den genannten Druckschriften für die Fehlermodelle für n-Tor Netzwerkanalysatoren vorgestellten Kalibrierverfahren sind direkte Mehrtor-(oder Multiport-) Kalibrierverfahren, die zwar exakt sind, bei denen jedoch in der Praxis die erforderliche Messungen und Korrekturen sehr zeitaufwendig sind. Hinzu kommt, daß diese Verfahren für Netzwerkanalysatoren, die lediglich drei oder vier Meßstellen aufweisen, die über zwei innere Tore und eine Schaltmatrix mit den Meßtoren verbunden sind, nicht einsetzbar sind. Diese Netzwerkanalysatoren stellen jedoch die bei weitem größte Gruppe an eingesetzten Netzwerkanalysatoren dar.

In modernen NWAs mit vier Meßstellen wird auch ein in der Dissertationsschrift "Sichere Verfahren zur Kalibrierung von Netzwerkanalysatoren für koaxiale und planare Leitungssysteme", Institut für Hochfrequenztechnik, Ruhr-Universität Bochum, 1995, von H. Heuermann beschriebenes TRL (T: Thru, L: Line, R: Reflect)-Kalibrierverfahren eingesetzt. Bei diesem Verfahren brauchen, abgesehen von der Durchverbindung T, die verbleibenden zwei Standards L und R nur noch teilweise bekannt zu sein. In der genannten Schrift wurde aber auch gezeigt, daß das TRL-Verfahren lediglich als ein Spezialfall einer allgemeinen Theorie für das sogenannte Zwei-Fehlermatrizen-Zweitormodell betrachtet werden kann.

Als Meßobjekte von Multiportmessungen kommen einerseits eine Reihe von Objekten mit unsymmetrischen Anschlüssen (i.d.R. 50 Ω-Ports), wie z.B. Koppler, Signalteiler und Frequenzweichen, und anderseits Objekte mit Anschlüssen verschiedener Moden, wie z.B. Symmetrieglieder und SAW-Filter, in Betracht. Bei letzteren ist der Stand der Technik der, daß der Gegentaktmode über einen zusätzlichen Verarbeitungsschritt unter Einbindung eines idealen Transformators in einem unsymmetrischen Mode zurückgewandelt werden.

Der Erfindung liegt die Aufgabe zugrunde, ein Verfahren zur Verfügung zu stellen, die eine universal einsetzbare, genaue und wenig zeitaufwendige Fehlerkorrektur von mittels eines Netzwerkanalysators gemessenen Streuparametern von Meßobjekten erlauben.

Diese Aufgabe wird erfindungsgemäß zum einen gelöst durch ein Verfahren nach Anspruch 1.

Zwischen den n Meßtoren eines Netzwerkanalysators können über einen entsprechenden Anschluß eines Kalibrierstandards Signalpfade gebildet werden. Bei n Meßtoren sind $k = n \cdot \dfrac{n-1}{2}$ verschiedene Kombinationen von jeweils 2 Meßtoren möglich, und damit auch k solcher Signalpfade zwischen jeweils 2 Meßtoren. Die für die Zweitor-Kalibrierung erforderliche Erfassung von auf die Meßtore zulaufenden Signale und der von den Meßtoren kommenden Signale kann dabei beliebig ausgestaltet werden. So können die n Meßtore des Netzwerkanalysators sowohl über eine Schaltmatrix und innere Meßtore mit 3 bzw. 4 Meßstellen, als auch nur über eine Schaltmatrix mit 3, 4, oder n+1 Meßstellen, als auch ohne Schaltmatrix direkt mit 2*n Meßstellen verbunden sein.

Als Kalibrierstandards sind wie in den bekannten Zweitor-Kalibrierverfahren n-Toren, Zweitoren und/oder einfachen bis n-fachen Eintoren einsetzbar, die mit einer Ausnahme vorzugsweise vollständig bekannt oder selbstkalibrierfähig sind. Wie in der oben genannten Dissertationsschrift näher ausgeführt, kommen dabei als Standards mit Selbstkalibrierfähigkeiten zur Zeit nur Zweitorstandards in Frage kommen, die mit mindestens 4 Meßstellen vermessen werden. Die erwähnte Ausnahme besteht, wie in den bekannten Zweitor-Kalibrierverfahren, aus mindestens einem erforderlichen Zweitor endlicher Transmissionsdämpfung, das nicht vorzugsweise vollständig bekannt oder selbstkalibrierend ist. Wenn die Transmissionsdämpfung dieses Zweitors aber bekannt ist, so brauchen andererseits eingesetzte n-fache Eintore nicht vollständig bekannt zu sein. Die in dem erfindungsgemäßen Verfahren und dem erfindungsgemäßen Netzwerkanalysator als Kalibrierstandard einsetzbaren n-fachen Eintore können entweder ein n Tor bestehend aus n Eintoren oder ein Eintor, das an jedem der n Meßtore angeschlossen und vermessen wird, sein.

Die Erfindung baut auf die in bekannten Netzwerkananlysatoren implementierten Zweitor-Kalibrierverfahren auf. Nachdem ein solches bekanntes Kalibrierverfahren für die Bereitstellung von Fehlertermen für eine erste Fehlerkorrektur durchgeführt wurde, erlaubt es die Erfindung, mittels eines sehr einfachen, zusätzlichen De-embedding Schrittes mit nur wenigen Messungen genaue Multiportmeßwerte zu erhalten, die das Multiportverhalten des Meßobjekts berücksichtigen.

Für jedes Meßtor existieren für verschiedene Zustände verschiedene Reflexionsfaktoren. Aktive Zustände sind dabei gegeben, wenn das Meßtor auf Senden oder Empfangen geschaltet ist, und ein inaktiver Zustand ist gegeben, wenn das Meßtor abgeschaltet ist. Die bekannten Zweitor-Kalibrierverfahren bestimmen und verwenden ausschließlich die Reflexionsparameter von Zweitoren im aktiven Zustand. Damit können allerdings die Korrelationen zwischen den n Meßtoren nicht berücksichtigt werden, die das Multiportverhalten des Meßobjekts bestimmen.

Der vorgeschlagene De-embedding Schritt besteht nun darin, nach einer bekannten, k-fachen Zweitor-Kalibrierung die Reflexionsfaktoren zumindest einiger der n Meßtore des Netzwerkanalysators im abgeschalteten Zustand zu bestimmen. Die Bestimmung erfolgt dabei anhand von Ergebnissen von Zweitor-Messung an mindestens einem an Meßtore im aktiven und/oder inaktiven Zustand geschalteten Kalibrierstandard.

Für Netzwerkanalysatoren, die lediglich drei oder vier Meßstellen aufweisen, die über zwei innere Tore mit den n Meßtoren verbunden sind, ist das inaktive und das aktive Reflexionsverhalten der Meßtore unterschiedlich. Bei solchen Netzwerkanalysatoren werden die inaktiven Reflexionsfaktoren bestimmt, indem jeweils auf Senderseite die Reflexionen der Zweitore vermessen werden, während das sonst als Empfänger fungierende Meßtor abgeschaltet ist. Zusätzlich sollten die gemessenen inaktiven Reflexionsfaktoren fehlerbereinigt werden, denn insbesondere aufgrund des zwischen die Toren geschalteten Kalibrierstandards weicht der gemessene Faktor von dem tatsächlichen inaktiven Reflexionsfaktor ab. Hierzu werden die Zweitore zusätzlich in beide Richtungen mit dem gleichen Kalibrierstandard vermessen, während jeweils ein Tor als Sender und das andere Tor als Empfänger fungiert, also beide Tore aktiv geschaltet sind. Die Meßergebnisse der aktiven Messungen können dann zur Fehlerbereinigung der gemessenen inaktiven Reflexionsparameter herangezogen werden.

Für Netzwerkanalysatoren, die 2*n oder n+1 Meßstellen aufweisen, ist das inaktive und das aktive Reflexionsverhalten der Meßtore identisch. In dem Fall brauchen deshalb die Zweitore ausschließlich vermessen zu werden, während beide Tore aktiv geschaltet sind. Als zu bestimmende Reflexionsparameter der Meßtore im inaktiven Zustand können dann einfach die Reflexionsparameter der Meßtore im aktiven Zustand verwendet werden.

Die bestimmten Reflexionsfaktoren der Meßtore im inaktiven Zustand können dann einer zweiten Fehlerkorrektur der Streuparameter des Meßobjekts zugrundegelegt werden, bei der das Multiportverhalten mit guter Genauigkeit berücksichtigt wird. Mit dem vorgeschlagenen Verfahren können dadurch von Systemfehlern wie Übersprechen und Fehlanpassungen befreite Messungen sowohl in koaxialen Systemen als auch auf Halbleitersubstraten durchgeführt werden.

Basierend auf dem erfindungsgemäßen Verfahren und dem erfindungsgemäßen Netzwerkanalysator bzw. Schaltmodul lassen sich somit aus vorhandenen Zweitorlösungen sehr schnell komplexe Multiportlösungen für die Netzwerkanalyse umsetzen, die weit weniger Zeitaufwand erfordern als die bekannten Multiportverfahren. Das erfindungsgemäße Verfahren stellt somit ein De-embedding Multiport Verfahren DMV dar, das wesentlich kostengünstiger ist als die bekannten, auf einer einzigen Kalibrierung beruhenden Multiport-Kalibrierverfahren. Vor allem aber läßt sich die Erfindung auch auf die Netzwerkananlysatoren anwenden, bei denen 3 oder 4 Meßstellen über zwei innere Tore und eine Schaltmatrix mit den Meßtoren verbunden sind, was mit den bekannten Multiport-Kalibrierverfahren nicht möglich ist.

Ein besonderer Vorteil des vorgeschlagenen Verfahrens besteht in der einfachen Implementierungsmöglichkeit in einem Netzwerkanalysator. Weiterhin ist vorteilhaft gegenüber den bekannten Multiport-Kalibrierverfahren, daß nicht sämtliche Signalwege vermessen werden müssen, wenn nur ein oder einige Streuparamter gesucht sind. Für eine vollständige Fehlerkorrektur der Streumatrix eines Meßobjekts müssen jedoch alle k möglichen Signalwege zwischen zwei Meßtoren vermessen und daraus die Reflexionsparameter sämtlicher Meßtore im inaktiven Zustand bestimmt werden.

Die Ansprüche des vorgestellten Verfahrens an die Kalibrierstandards sind die gleichen wie bei den bekannten Zweitor- und Multiport-Kalibrierverfahren. Dieses ist für die Verfügbarkeit der Kalibrierstandards und somit für den praktischen Einsatz ein sehr wichtiger Aspekt. Da das vorgestellte Verfahren den Einsatz einer sehr großen Menge von Kalibrierstandards erlaubt, ermöglicht es folglich in jedem Leitungssystem eine Lösungsmöglichkeit der präzisen Realisierbarkeit der Standards und damit eine ganz neue Perspektive bei der Vermessung von Mehrtoren.

Selbst wenn die Reflexionsfaktoren sämtlicher n Meßtore vermessen werden sollen, ist die Anzahl der notwendigen Kontaktierungen einzelner Standards bei dem vorgeschlagenen Verfahren nicht größer als bei dem Multiport-10-Term-Verfahren aus der DE 199 18 697 A1. Lediglich im Vergleich zum Multiport-7-Term-Verfahren aus der DE 199 18 960 A1 sind zusätzliche Verbindungen notwendig.

Vorteilhafte Ausgestaltungen des erfindungsgemäßen Verfahrens und des erfindungsgemäßen Netzwerkanalysator gehen aus den Unteransprüchen hervor.

In einer bevorzugten Ausgestaltung des erfindungsgemäßen Verfahrens werden zur Bestimmung der Reflexionsfaktoren von Zweitoren im inaktiven Zustand die Durchverbindungen der nach einem bekannten Verfahren erfolgten Zweitor-Kalibrierungen herangezogen, so daß kein zusätzlicher Verbindungsaufwand erforderlich ist, bzw. bei einem zugrunde liegenden Zweitor-7-Term-Verfahren ein reduzierter zusätzlicher Verbindungsaufwand. Darüber hinaus können die aus den Zweitor-Kalibrierungen bereits bekannten Ergebnisse der Durchverbindungsmessungen der zweitore im aktiven Zustand verwendet werden. Zwar muß je nach Netzwerkanalysator für jeden zu bestimmenden Reflexionsparameter eines Meßtors im inaktiven Zustand eine weitere Zweitor-Messung mit jeweils einem abgeschalteten Meßtor erfolgen, aber wesentlich zeitaufwendiger als die Messungen selber ist das Herstellen neuer Verbindungen. Das erfindungsgemäße Verfahren erlaubt es also, den De-embedding Schritt unter Einbeziehung der seit langem bekannten und in jedem Netzwerkanalysator implementierten Zwei-Tor-Fehlerkorrekturverfahren durchzuführen.

Das vorgeschlagene De-embedding Verfahren kann insbesondere mit allen Zweitor-Kalibrierverfahren nach der 10-Term und der 7-Term Technik arbeiten, die beispielsweise als Ausgangspunkt in den bereits erwähnten Druckschriften DE 199 18 697 A1 und DE 199 18 960 A1 beschrieben werden. Für die bis zu k benötigten Kalibriermessungen als Grundlage für die erste Fehlerkorrektur genügt es, wenn man über die üblichen Standards für die 10-Term oder 7-Term Verfahren, z.B. TMSO, TMR oder TLR, verfügt. Hierbei steht T für eine Durchverbindung, M für eine bekannte Impedanz, S für einen Kurzschluß und O für einen Leerlauf. Mit L bezeichnet man eine Leitung und mit R einen Reflexionsstandard. Vorteilhafte konkrete Ausgestaltungen von mit der Erfindung kombinierbaren Zweitor-Kalibrierverfahren ergeben sich aus den Unteransprüchen 5 bis 8.

Es sind vier verschiedene Netzwerkanalysator-Konstruktionen technisch sinnvoll. Für jede der Konstruktionen läßt sich das erfindungsgemäße Verfahren einsetzen.

Als erste und preisgünstigste Konstruktion ist ein Netzwerkanalysator mit lediglich drei Meßstellen zu nennen. Zwei der drei Meßstellen sind mit jeweils einem von zwei inneren Tore direkt verbunden, und die dritte Meßstelle ist über einen Schalter mit beiden inneren Toren verbindbar. Eine Schaltmatrix verbindet weiterhin die zwei inneren Tore des NWA mit den n äußeren Meßtoren und realisiert somit die k notwendigen Signalzweige. Für diese Konstruktion ist keines der bekannten Multiport-Kalibrierverfahren einsetzbar. Als schnelle aber nicht sehr preisgünstige Konstruktion kommt außerdem ein Netzwerkanalysator in Betracht, in dem die n Meßtore über eine Schaltmatrix aber ohne innere Tore mit n+1 Meßstellen verbunden sind. Eine solche schnelle Konstruktion wird beispielsweise in der DE 199 18 697 A1 näher beschrieben.

Für diese ersten beiden Konstruktionen sind in dem erfindungsgemäßen Verfahren k Zweitor-10-Term Verfahren durchzuführen. Die Anforderungen an die Kalibrierstandards und deren Anzahl ist gleich zu dem aus der DE 199 18 697 A1 bekannten Multiport-10-Term-Verfahren. Neu ist die erfindungsgemäße, zusätzliche Ermittlung der Reflexionsgrößen der n Meßtore im inaktiven Zustand, wobei im zweiten Fall die Reflexionsgrößen der n Meßtore im inaktiven Zustand den Reflexionsgrößen der n Meßtore im aktiven Zustand gleichgesetzt werden können. Diese ersten zwei Konstruktionen können insbesondere mit dem in Unteranspruch 5 vorgeschlagenen Verfahren eingesetzt werden.

Als dritte und wiederum preisgünstige Konstruktion ist ein Netzwerkanalysator mit vier Meßstellen zu nennen. Dabei ist sind jeweils zwei der Meßstellen direkt mit jeweils einem von zwei inneren Toren des NWA verbunden. Wie in der ersten Konstruktion werden die beiden inneren Tore des NWA von einer Schaltmatrix mit den n äußeren Meßtoren des somit realisierten Multiport-Netzwerkanalysators verbunden. Auch für diese Konstruktion ist keine der bekannten Multiport-Kalibrierverfahren einsetzbar. Als weitere schnelle, aber auch sehr teuere Alternative ist schließlich ein Netzwerkanalysator zu nennen, bei dem die n Meßtore ohne angeschlossene Schaltmatrix direkt mit 2*n Meßstellen verbunden werden. Eine solche Konstruktion wird beispielsweise in der DE 199 18 960 A1 näher beschrieben.

Für das erfindungsgemäße Verfahren werden für die beiden letztgenannten Konstruktionen vorzugsweise k Zweitor-7-Term-Verfahren durchgeführt. Die Anforderungen an die Kalibrierstandards und die Anzahl ist gleich wie an das aus der DE 199 18 960 A1 bekannte Multiport-Kalibrierverfahren, aber die Anzahl der Kontaktierungen ist unterschiedlich. Neu ist wiederum die für das De-embedding notwendige Ermittlung der Reflexionsgrößen der n Meßtore in inaktivem Zustand, wobei bei der vierten Konstruktion die Reflexionsgrößen der n Meßtore im inaktiven Zustand den Reflexionsgrößen der n Meßtore im aktiven Zustand gleichgesetzt werden können. Die 10-Term-Verfahren können bei dieser Konstruktion ebenfalls eingesetzt werden, benötigen jedoch hochwertigere und zahlreichere Kalibrierstandards und -messungen. Diese Konstruktionen können insbesondere mit einem der in den Unteransprüchen 6 bis 8 vorgeschlagenen Verfahren eingesetzt werden.

Sind in einem Netzwerkanalysator 2*n oder n+1 Meßstellen vorgesehen, so können die n Meßtore direkt bzw. über einen Umschalter mit den Meßstellen verbunden sein. Alternativ kann aber auch eine Schaltmatrix vorgesehen werden, die geeignet ist, jedes der n Meßtore des Netzwerkanalysators jeweils über mindestens eine der Meßstellen mit zwei inneren Toren des Netzwerkanalysators zu verbinden. Die n+1 bzw. 2*n Meßstellen können dabei auch in die Schaltmatrix integriert sein. Auf diese Weise benötigt ein Netzwerkanalysator nur zwei innere Tore, weist aber dennoch n+1 oder 2*n Meßstellen auf.

Die Ansprüche 6 bis 8 schließen den Einsatz der bekannten 7-Term Zweitor-Kalibrierverfahren mit den Namen TAN, TNA, TRL, TLR, LLR, LRL, TAR, TMR, TRM, UMSO, TMN, LNN, TZU, TZY, TYU, LZY, ZZU, YYU, usw. ein (T: Thru, R: Reflect, L: Line, A: Attenuator, M: Match, U: Unknown, S: Short, O: Open, N: Network, Z: Serienwiderstand, Y: Parallelwiderstand). Für Einzelheiten zu diesen Verfahren wird auf die oben bereits genannte Dissertationsschrift verwiesen. All diese zur Klasse der 7-Term-Verfahren gehörenden Algorithmen lassen sich mit ihren Vorteilen im Rahmen des erfindungsgemäßen Verfahrens bzw. in einem erfindungsgemäßen Netzwerkanalysator implementieren. Sämtliche Verfahren werden in ihrer klassischen Einsatzform k mal verwendet. Demzufolge muß jeder Zweitorstandard k-malig und jeder Eintorstandard n-malig kontaktiert werden. Deshalb hebt sich das hier vorgestellte Verfahren bzgl. des Gesamtkalibrierprozesses deutlich von den Multiport 7-Term-Kalibrierverfahren nach der DE 199 18 960 A1 ab. Bei Multiportproblemen mit mehr als 3 Toren sind die Verfahren am interessantesten, die wenige Zweitorstandards beinhalten, da k viel größer ist als n.

In den Unteransprüchen 7 und 8 wurden die praktisch sehr bedeutsamen Anwendungen der 7-Term-Verfahren TRL und TMR herausgehoben. Bei dem sehr interessanten TMR-DMV stehen bei der Wahl der Kalibrierstandardkombinationen eine Vielzahl von Alternativen in der Reihenfolge der Kontaktierung der Eintore zur Auswahl. Jedoch ist vorgegeben, daß man alle Tore mittels einer bekannten Zweitorverbindung (i.d.R. eine Durchverbindung T) einmal verbinden muß. Des weiteren muß an jedem Tor ein bekannter Impedanzabschluß, z.B. ein Wellensumpf M, und ein Reflexionsstandard R, dessen Reflexionsverhalten an jedem Tor lediglich gleich aber nicht bekannt sein muß, angeschlossen werden.

In Anspruch 9 wird ergänzend eine vorteilhafte Möglichkeit zur Behandlung von Meßobjekten mit Gegentakt- und Gleichtaktmoden an den Anschlüssen vorgeschlagen. Demnach wird das Meßobjekt anstatt mit den üblichen Streuparametern für den unsymmetrischen Mode mit Streuparametern für den Gleich- und Gegentaktmode beschrieben. Das Verfahren zeichnet sich deshalb gegenüber dem bisher benutzten Verfahren mit dem idealen Transformator dadurch aus, daß sämtliche Verlustmechanismen als einzelne physikalisch rückführbare Größen untergliedert werden, und es somit den Entwicklern deutlich mehr Informationen gibt, um das Produkt in seinen elektrischen Eigenschaften zu verbessern. Mit dieser Ausgestaltung des erfindungsgemäßen Verfahrens lassen sich Objekte wie SAW-Filter und Symmetrieglieder einfach, schnell und sehr detailliert bestimmen.

Die Mittel des erfindungsgemäßen Schaltmoduls sind vorzugsweise in Software implementiert. Ferner kann das Schaltmodul eine eigenständige neue Einheit darstellen, oder eine bereits in dem jeweiligen NWA vorhandene Komponente, in die die beanspruchten Mittel zusätzlich integriert wurden.

Die Erfindung wird im folgenden unter Bezugnahme auf eine Zeichnung näher erläutert. Dabei zeigt

Fig. 1 schematisch einen NWA mit 3 Meßstellen, 2 inneren Toren und n äußeren Meßtoren,
Fig. 2 schematisch einen NWA vier Meßstellen, zwei inneren Toren und n äußeren Meßtoren,
Fig. 3 schematisch einen NWA mit 3 Meßstellen und n äußeren Meßtoren,
Fig. 4 schematisch einen NWA mit vier Meßstellen und n äußeren Meßtoren,
Fig. 5 schematisch einen NWA mit 2*n Meßstellen und n äußeren Meßtoren,
Fig. 6 schematisch die Bestimmung von aktiven Reflexionsfaktoren in einem NWA entsprechend Figur 1,
Fig. 7 schematisch die Bestimmung von inaktiven Reflexionsfaktoren in einem NWA entsprechend Figur 1, und
Fig. 8 schematisch ein Blockschaltbild eines NWAs entsprechend Figur 2, für das die zweite Fehlerkorrektur von Streuparametern verdeutlicht wird.

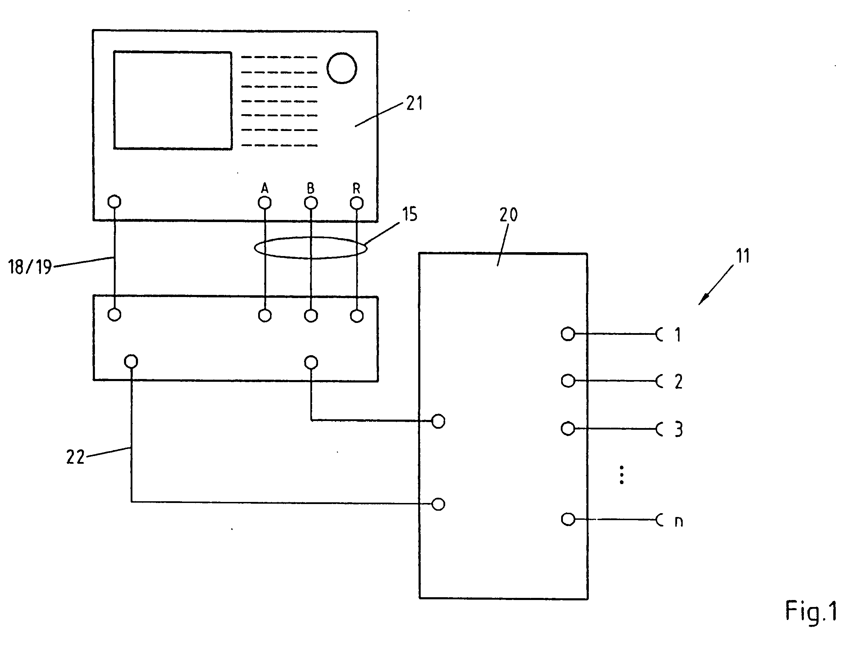

Zunächst werden anhand der Figuren 1 bis 5 Ausführungsbeispiele von NWAs beschreiben, für die das erfindungsgemäße De-embedding Verfahren eingesetzt werden kann.

Figur 1 stellt einen NWA mit drei Meßstellen 15, zwei inneren Toren 22 und n äußeren Meßtoren 11 dar. Eine Bedien- und Verarbeitungseinheit 21 ist über drei Meßstellen (A,B,R) 15 und Hochfrequenzspeiseleitungen 18, 19 mit zwei inneren Toren 22 des NWA verbunden. Die beiden inneren Tore 22 sind ihrerseits über ein Umschaltmodul 20 mit n äußeren Meßtoren 11 verbunden. Zwei der Meßstellen A, B erfassen von den äußeren Meßtoren 11 rücklaufende Signale und eine der Meßstellen R erfaßt zu den äußeren Toren 11 hinlaufende Signale. Die Hochfrequenzspeiseleitungen 18, 19 werden dabei verwendet, um hinlaufende Signale auf die Meßtore 11 zu geben, wobei nicht dargestellte Reflektometer das jeweilige Signal auch der Meßstelle R für die hinlaufende Welle zuführen. Das inaktive und das aktive Verhalten von Meßtoren ist in diesem NWA unterschiedlich. Die zweifache Fehlerkorrektur von gemessenen Streuparametern eines Meßobjekts erfolgt in diesem NWA und in den folgenden beschriebenen NWAs in der Verarbeitungseinheit 21, in der auch entsprechende Fehlerterme für die erste und die zweite Korrektur bestimmt und abgespeichert wurden. Für einen solchen NWA kann weder das bekannte 7-Term- noch das bekannte 10-Term-Multiport-Kalibrierverfahren eingesetzt werden. Als Grundlage für das erfindungsgemäße Verfahren kommen zwar auch keine 7-Term Zweitor-Kalibrierverfahren in Frage, wohl aber 10-Term Zweitor-Kalibrierverfahren.

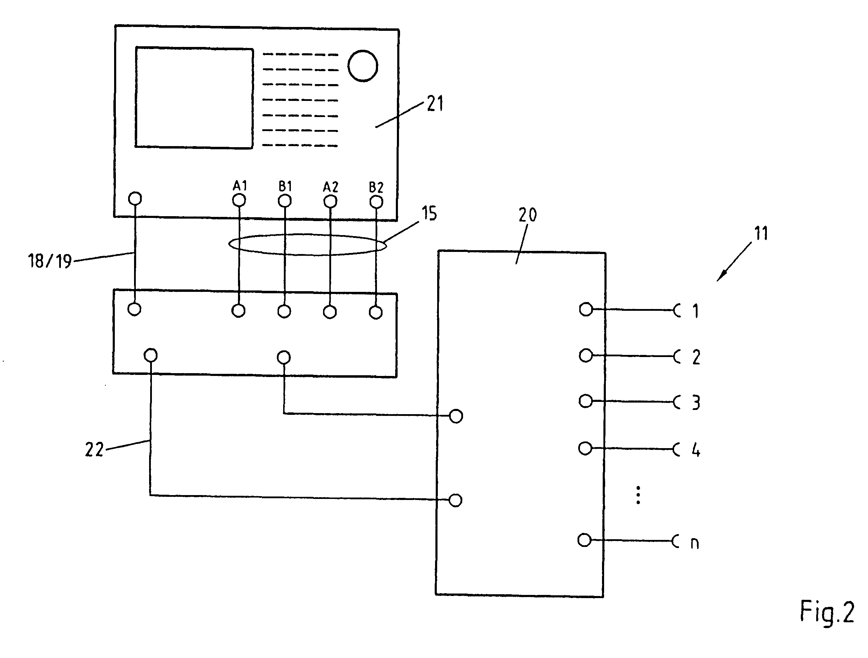

Figur 2 stellt einen NWA mit vier Meßstellen 15, zwei inneren Toren 22 und n äußeren Meßtoren 11 dar. Eine Bedien- und Verarbeitungseinheit 21 ist über vier Meßstellen (A1,B1,A2,B2) 15 und zwei Hochfrequenzspeiseleitungen 18, 19 mit zwei inneren Toren 22 des NWA verbunden, die ihrerseits über ein Umschaltmodul 20 mit n äußeren Meßtoren 11 verbunden sind. Die Hochfrequenzspeiseleitungen 18, 19 geben wiederum hinlaufende Signale auf die äußeren Meßtore 11. Da diesmal vier Meßstellen 15 vorgesehen sind, können zusätzlich innerhalb des Geräts reflektierte Wellen erfaßt werden. Das inaktive und das aktive Verhalten von Meßtoren ist wiederum verschieden. Auch hier kann weder das bekannte 7-Term- noch das bekannte 10-Term-Multiport-Kalibrierverfahren eingesetzt werden. Als Grundlage für das erfindungsgemäße Verfahren kommen aber aufgrund der Möglichkeit der Erfassung von in dem Gerät reflektierten Wellen sowohl 10-Term Zweitor-Kalibrierverfahren als auch 7-Term Zweitor-Kalibrierverfahren in Frage.

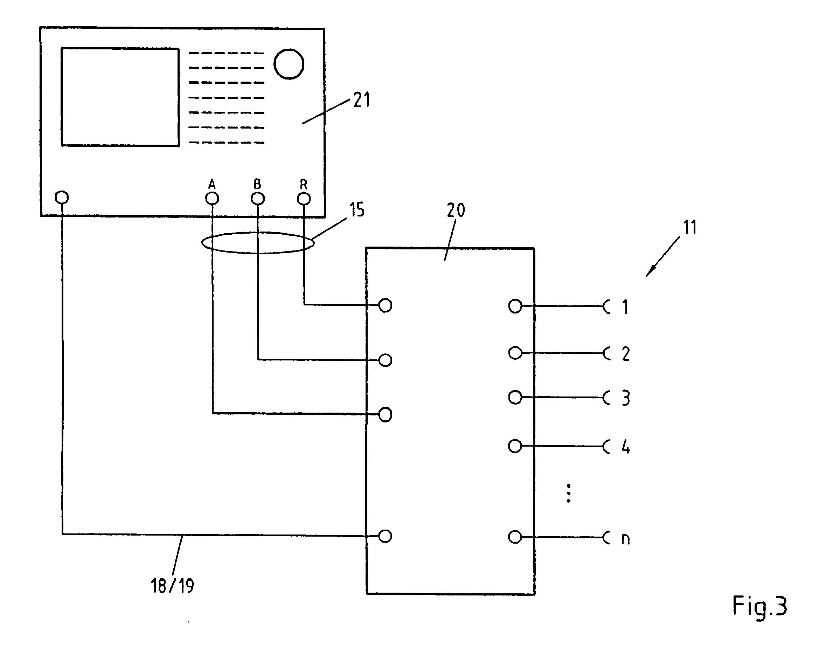

Figur 3 stellt wiederum einen NWA mit drei Meßstellen 15 und n äußeren Meßtoren 11 dar. In diesem Fall ist eine Bedien- und Verarbeitungseinheit 21 jedoch über die drei Meßstellen (A,B,R) 15 und Hochfrequenzspeiseleitungen 18, 19 direkt mit einem Umschaltmodul 20 verbunden. Das Umschaltmodul 20 ermöglicht eine unmittelbare Verbindung zwischen den Meßstellen 15 und den n äußeren Meßtoren 11. Im Gegensatz zu den NWAs aus den Figuren 1 und 2 ist das inaktive und das aktive Verhalten identisch. Bei dieser Konstruktion wäre das bekannte 10-Term-Multiport-Verfahren einsetzbar. Als Grundlage für das erfindungsgemäße Verfahren kommen wieder keine 7-Term Zweitor-Kalibrierverfahren, wohl aber 10-Term Zweitor-Kalibrierverfahren in Frage.

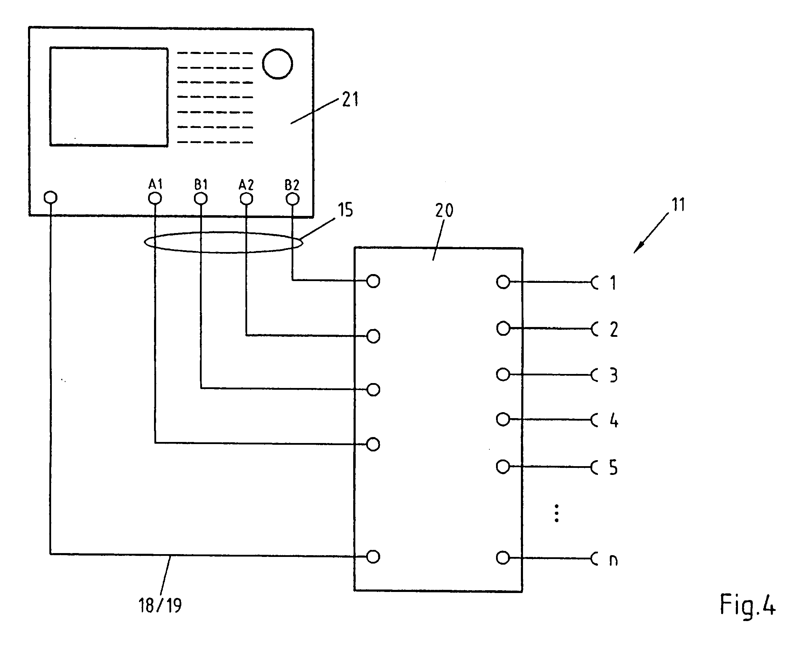

Figur 4 stellt ähnlich wie der NWA aus Figur 3 einen NWA dar, bei dem Meßstellen 15 und Hochfrequenzspeiseleitungen 18, 19 direkt über ein Umschaltmodul 20 mit n äußeren Meßtoren 11 verbunden sind. In Figur 4 sind allerdings wieder vier Meßstellen (A1,B1,A2,B2) 15 vorgesehen. Alternativ könnten auch n+1 Meßstellen 15 vorhanden sein. Wie bei dem NWA aus Figur 3 ist das inaktive und das aktive Verhalten identisch. Bei dieser Konstruktion wäre neben dem bekannte 10-Term-Multiport-Verfahren auch das bekannte 7-Term-Multiport-Verfahren einsetzbar. Wie bei dem NWA aus Figur 2 kommen als Grundlage für das erfindungsgemäße Verfahren außerdem wieder sowohl 7-Term Zweitor-Kalibrierverfahren, als auch 10-Term Zweitor-Kalibrierverfahren in Frage.

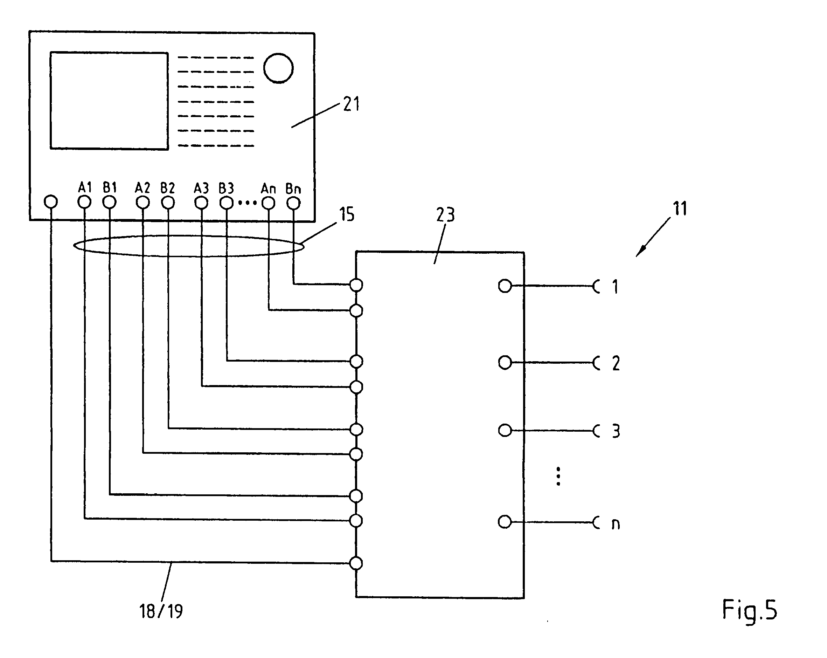

Schließlich zeigt Figur 5 einen NWA, bei dem eine Bedien- und Verarbeitungseinheit 21 über 2*n Meßstellen (A1,B1-An,Bn) 15 und Hochfrequenzspeiseleitungen 18, 19 direkt mit einem Verbindungsmodul 23 verbunden sind. Dieses Verbindungsmodul 23 ermöglicht eine Verbindung der Meßstellen 15 mit den n äußeren Meßtoren 11 ohne Umschalten, da für jedes äußeres Meßtor 11 eine Meßstelle A1-An für hinlaufende und eine Meßstelle B1-Bn für rücklaufende Wellen vorhanden ist. Wie bei den beiden NWAs aus Figur 3 und Figur 4 ist das inaktive und das aktive Verhalten identisch. Auch bei dieser Konstruktion wäre das bekannte 10-Term-Multiport-Verfahren und das bekannte 7-Term-Multiport-Verfahren einsetzbar. Als Grundlage für das erfindungsgemäße Verfahren kommen außerdem sowohl 7-Term Zweitor-Kalibrierverfahren, als auch 10-Term Zweitor-Kalibrierverfahren in Frage.

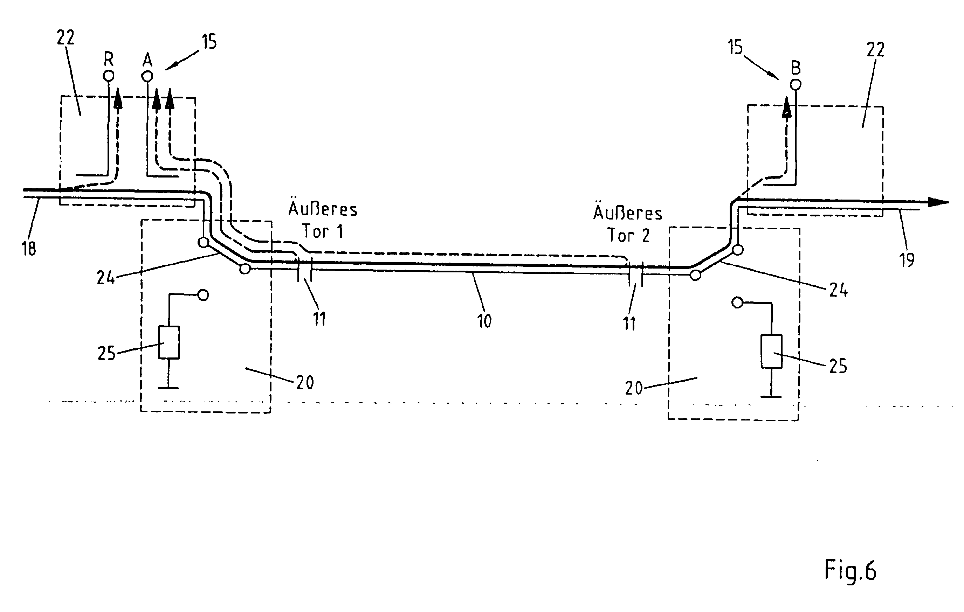

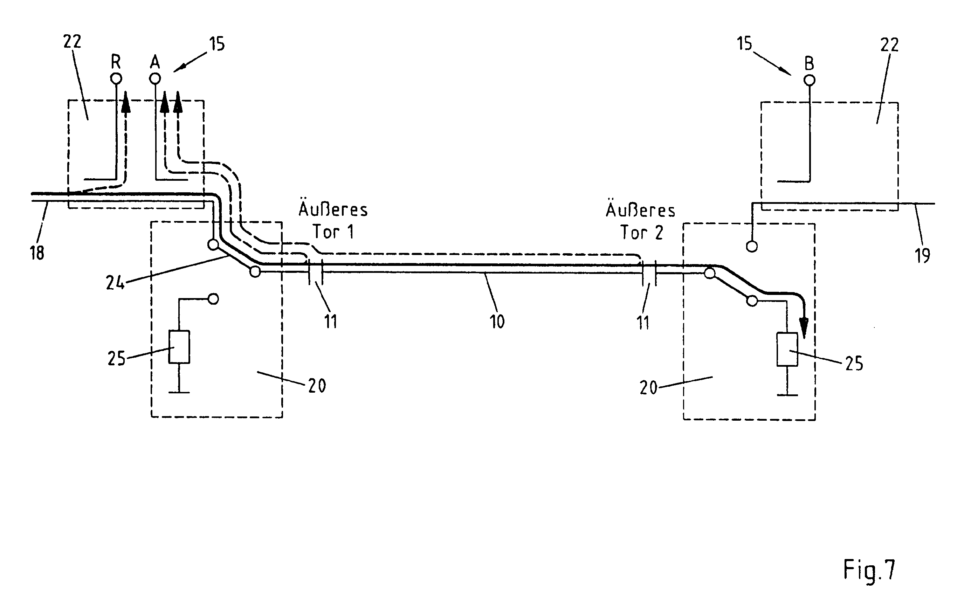

Figur 6 veranschaulicht schematisch die bekannte Ermittlung von aktiven Reflexionsfaktoren durch Zweitormessungen in einem NWA gemäß Figur 1. Figur 7 veranschaulicht schematisch die erfindungsgemäße Ermittlung von inaktiven Reflexionsfaktoren durch Zweitormessungen in einem NWA gemäß Figur 1. In beiden Figuren ist dabei der gleiche Ausschnitt aus einem NWA mit einem angeschlossenem Kalibrierstandard 10 gezeigt.

In beiden Figuren 6 und 7 ist eine der Hochfrequenzspeiseleitungen 18 über ein erstes inneres Tor 22 und über das Umschaltmodul 20 mit einem ersten äußeren Meßtor 11 der n äußeren Meßtore verbunden. Über eine als Kalibrierstandard eingesetzte Durchverbindung 10 ist das erste äußere Meßtor 11 mit einem zweiten der n äußeren Meßtore 11 verbunden. Die beiden Meßtore 11 bilden ein zu vermessendes Zweitor. Das zweite äußere Meßtor 11 ist über das Umschaltmodul 20 und über das zweite innere Tor 22 mit der zweiten Hochfrequenzspeiseleitung 19 verbunden. In dem Umschaltmodul 20 ist für eine schaltbare Verbindung zwischen dem ersten inneren Tor 22 und dem ersten äußeren Meßtor 11 ein erster Schalter 24 vorgesehen, der das erste innere Tor 22 entweder mit dem ersten äußeren Meßtor 11 verbindet oder über einen Widerstand 25 erdet. Ein entsprechender zweiter Schalter 24 ist in dem Umschaltmodul 20 für eine schaltbare Verbindung zwischen dem zweiten inneren Tor 22 und dem zweiten äußeren Meßtor 11 vorhanden. Des weiteren sind die mit den zwei inneren Toren 22 verbundenen drei Meßstellen 15 dargestellt. Die Meßstelle R ist dabei geeignet, über einen Reflexiometer die auf das erste äußere Meßtor 11 zulaufenden Wellen zu erfassen, die Meßstelle A ist geeignet, die von dem ersten äußeren Meßtor 11 zurücklaufenden Wellen zu erfassen, und die Meßstelle B ist geeignet, die von dem zweiten äußeren Meßtor 11 kommenden Wollen zu erfassen.

Zunächst wird nun die Ermittlung von aktiven Reflexionsfaktoren anhand von Figur 6 erläutert. Für die Bestimmung des aktiven Reflexionsfaktors des zweiten äußeren Meßtors 11 wird das erste äußere Meßtor 11 als Sender und das zweite äußere Meßtor 11 als Empfänger eingesetzt. Hierzu wird zum einen in dem Umschaltmodul 20 über den ersten Schalter 24 eine Verbindung zwischen dem ersten inneren Tor 22 und dem ersten äußeren Meßtor 11 hergestellt und über den zweiten Schalter 24 eine Verbindung zwischen dem zweiten äußeren Meßtor 11 und dem zweiten inneren Tor 22.

Anschließend wird durch die erste Hochfrequenzspeiseleitung 18 ein Signal über das erste innere Tor 22 und das Umschaltmodul 20 auf das erste äußere Meßtor 11 geleitet, wobei die Meßstelle R einen Meßwert für das Signal erfaßt. Ein Teil des an dem ersten äußeren Meßtor 11 ankommenden Signals wird sofort reflektiert und zurück über das Umschaltmodul 20 und das erste innere Tor 22 der Meßstelle A zugeleitet. Der nicht reflektierte Teil des Signals wird über den Kalibrierstandard 10 an das zweite äußere Meßtor 11 weitergeleitet. An dem zweiten äußeren Meßtor 11 wird ein weiterer Anteil des Signals reflektiert und über das erste äußere Meßtor 11, den Umschalter 20 und das erste innere Tor 22 ebenfalls der Meßstelle A zugeleitet. Der verbleibende Rest des Signals wird über das zweite äußere Meßtor 11, das Umschaltmodul 20 und das zweite innere Tor 22 auf die zweite Hochfrequenzspeiseleitung 19 geleitet, wobei die Meßstelle B diesen Anteil des Signals erfaßt.

In gleicher Weise kann im Anschluß das zweite äußere Meßtor 11 als Sender und das erste äußere Meßtor 11 als Empfänger eingesetzt werden, um die entsprechenden Meßwerte für den aktiven Reflexionsfaktor des ersten äußeren Meßtors 11 zu bestimmen. Die Meßstelle R wird dafür so geschaltet, daß sie geeignet ist, auf das zweite äußere Meßtor 11 zulaufende Wellen zu erfassen. Aus den von den Meßstellen 15 erfaßten Werten können auf bekannte Weise die aktiven Reflexionsfaktoren der beiden äußeren Meßtore 11 ermittelt werden.

Die Ermittlung von inaktiven Reflexionsfaktoren bei einem NWA, bei dem aktives und inaktives Verhalten unterschiedlich ist, wird nun anhand von Figur 7 erläutert. Eine solche Ermittlung ist aus herkömmlichen Kalibrierverfahren nicht bekannt. Für die Bestimmung der inaktiven Reflexionsfaktoren wird wiederum zunächst das erste äußere Meßtor 11 als Sender eingesetzt, das zweite äußere Meßtor 11 dagegen wird abgeschaltet. Für die Abschaltung wird in dem Umschaltmodul 20 der zweite Schalter 24 so umgeschaltet, daß er das zweite äußere Meßtor 11 mit dem zweiten Widerstand 25 verbindet statt mit dem zweiten inneren Tor 22.

Dann wird erneut ein Signal über die erste Hochfrequenzleitung 18 auf das erste äußere Meßtor 11 geschickt. Ein erster Anteil des Signals wird wieder an dem ersten äußeren Meßtor 11 reflektiert und ein weiterer Teil an dem zweiten äußeren Meßtor 11. Der zweite reflektierte Anteil unterscheidet sich jedoch von dem zweiten reflektierten Anteil des Signals in Figur 6, da das Signal an dem zweiten äußeren Meßtor 11 nun aufgrund der geänderten Stellung des zweiten Schalters 24 auf einen Abschlußwiderstand 25 zuläuft, statt über das zweite innere Tor 22 auf die zweite Hochfrequenzleitung 19 geführt zu werden.

Die Erfassung der hinlaufenden und der reflektierten Wellen entspricht der in Figur 6, nur daß hier kein Signal an der Meßstelle B erfaßt wird, da die Verbindung zu dieser Meßstelle B unterbrochen wurde. Aus den an den Meßstellen A und R gemessenen Werten kann jetzt ein Reflexionsfaktor für das zweite äußere Meßtor 11 im inaktiven Zustand bestimmt werden. Zusätzlich wird der ermittelte inaktive Reflexionsfaktor anhand der Meßwerte für die aktiven Reflexionsfaktoren einer Fehlerkorrektur unterzogen, um den Einfluß des Kalibrierstandards 10 zwischen den äußeren Meßtoren 11 aus dem inaktiven Reflexionsfaktor zu beseitige.

Zur Bestimmung des Reflexionsfaktors für die erste Meßstelle 11 im inaktiven Zustand wird der Vorgang erneut in entgegengesetzter Richtung und mit invertierten Schalterstellungen durchgeführt.

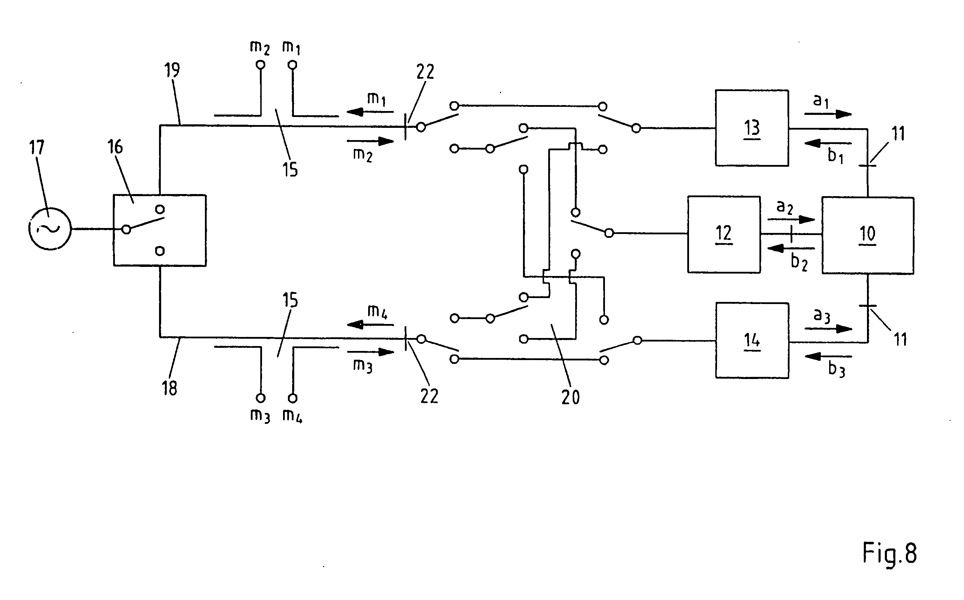

Das allgemeine Problem von n-Toren wird der Übersicht halber oft auf 3 Tore reduziert. Ebenso zeigt auch Figur 8 beispielhaft einen 3-Tor Mehrtor-Netzwerkanalysator. Der Mehrtor-Netzwerkanalysator in der Figur entspricht dem in der Beschreibungseinleitung als dritte praktisch relevante Konstruktion erwähnten Netzwerkanalysator bzw. dem Netzwerkanalysator aus Figur 2.

Der Netzwerkanalysator in Figur 8 weist eine Signalquelle 17 auf, die über einen realen Schalter 15 mit zwei Leitungszweigen 18, 19 verbunden ist. Jedem der Leitungszweige 18, 19 sind jeweils zwei als ideal angenommenen Meßstellen (m1,m2 bzw. m3,m4) 15 zugeordnet. Beide Leitungszweige 18, 19 sind des weiteren über innere Tore 22 und eine gemeinsame Schaltmatrix 20 aus ebenfalls als ideal angenommenen Schaltern mit einem beliebigen von drei Fehlernetzwerken 12, 13, 14 verknüpfbar. Die Schaltungsmatrix 20 entspricht dabei dem realen Umschaltmodul aus Figur 2. Jedes der drei Fehlernetzwerke 12, 13, 14 ist schließlich über ein Meßtor 11 mit einem Meßobjekts DUT 10 verbunden. DUT steht dabei für die englische Bezeichnung des Meßobjektes (device under test). Das Meßobjekt kann zum einen ein Objekt sein, dessen Reflexions- und Transmissionsparameter bestimmt werden sollen, und zum anderen verschiedene Kalibrierstandards, die für die Fehlerkorrektur der ermittelten Streuparameter eingesetzt werden.

Wird von der Quelle 17 ein Signal ausgegeben, so wird es von dem Umschalter 16, dessen Eigenschaften Reproduzierbarkeit, Reflexion, Langzeitstabilität usw. nicht in die Meßgenauigkeit eingehen, auf einen der zwei Leitungszweige 18, 19 und weiter zu einem der inneren Tore 22 geleitet. Über die Schaltungsmatrix 20 werden die Signale zu den Meßtoren 11 des DUT 15 und nach einer Reflexion an oder einer Transmission durch das DUT 15 wieder zurück auf die Leitungszweige 18, 19 geleitet. Die auf das DUT 15 zulaufenden Wellen sind mit $a_1$, $a_2$, $a_3$ bezeichnet und die von dem DUT 15 weglaufenden Wellen mit $b_1$, $b_2$, $b_3$, wobei jeweils der gleiche Index dem gleichen Meßtor 1, 2, 3 zugeordnet ist. Sämtliche Fehler der Schaltmatrix 20, der Meßstellen 15, der Verbindungskabel 18,19 etc. werden in den den einzelnen Toren 11 zugeordneten Fehlermatrizen der Fehlernetzwerke 12-14 zusammengefaßt.

Für die Bestimmung der Streuparameter eines angeschlossenen Meßobjekts 10 nimmt eine der Meßstellen $m_2$ bzw. $m_3$ an einem der Leitungszweige 18,19 ein Maß für die hinlaufende welle und die Meßstellen $m_1$, $m_4$ nehmen an dem entsprechenden der Leitungszweige 18,19 ein Maß für die von dem Meßobjekt 10 zurückkommende transmittierte bzw. reflektierte Welle auf.

Zunächst wird das NWA einem 7-Term Zweitor-Kalibrierverfahren unterzogen, um Fehlerterme für eine erste Fehlerkorrektur von Streuparametern bereitzustellen. Entsprechend der Ausführungen zu Figur 7 werden dann für eine zweite Fehlerkorrektur die fehlerbereinigten Reflexionsfaktoren $r_{ii}$ (i = 1 - 3) der drei Meßtore 11 im inaktiven Zustand bestimmt, wobei i=1 dem ersten Meßtor, i=2 dem zweiten Meßtor und i=3 dem dritten Meßtor zugeordnet ist.

Im Anschluß können für ein zu vermessene Objekt in bekannter Weise die Streuparameter als Rohmeßwerte erfaßt und einer ersten Fehlerkorrektur auf Grundlage der mit dem 7-Term Zweitor-Kalibrierverfahren bestimmten Fehlerterme unterzogen werden. Die gemessenen und einfach korrigierten Streuparameter bilden die neun Werte einer 3x3 Streumatrix und werden mit $S_{ij}^m$ (i = Reihe 1-3; j = Spalte 1-3) bezeichnet.

Aus den bereits einmal korrigierten Streuparametern des zu vermessenden Objekts und den erfindungsgemäß bestimmten und fehlerbereinigten Reflexionsfaktoren $r_{ii}$ kann nun die "tatsächliche" Streumatrix [S] des Meßobjektes 10 mit drei Meßtoren 11 in der Gleichung:

$$\begin{pmatrix} b_1 \\ b_2 \\ b_3 \end{pmatrix} = \underbrace{\begin{bmatrix} S_{11} & S_{12} & S_{13} \\ S_{21} & S_{22} & S_{23} \\ S_{31} & S_{32} & S_{33} \end{bmatrix}}_{[S]} \begin{pmatrix} a_1 \\ a_2 \\ a_3 \end{pmatrix} \qquad (1)$$

bestimmt werden. Dabei lassen sich für einen 3-Tor Mehrtor-Netzwerkanalysator über die bekannte Signalflußmethode die Gleichungen für die de-embeddeten Streuparameter einfach formulieren:

$$S_{11} = S_{11}^m - S_{13}^m S_{31}^m \frac{r_{33}}{1 - r_{33} S_{33}^m} - S_{12}^m S_{21}^m \frac{r_{22}}{1 - r_{22} S_{22}^m} \qquad (2)$$

$$S_{22} = S_{22}^m - S_{12}^m S_{21}^m \frac{r_{11}}{1 - r_{11} S_{11}^m} - S_{23}^m S_{32}^m \frac{r_{33}}{1 - r_{33} S_{33}^m} \qquad (3)$$

$$S_{33} = S_{33}^m - S_{13}^m S_{31}^m \frac{r_{11}}{1 - r_{11} S_{11}^m} - S_{23}^m S_{32}^m \frac{r_{22}}{1 - r_{22} S_{22}^m} \qquad (4)$$

$$S_{12} = S_{12}^m - S_{32}^m S_{13}^m \frac{r_{33}}{1 - r_{33} S_{33}^m} \qquad (5)$$

$$S_{13} = S_{13}^m - S_{12}^m S_{23}^m \frac{r_{22}}{1 - r_{22} S_{22}^m} \qquad (6)$$

$$S_{21} = S_{21}^m - S_{31}^m S_{23}^m \frac{r_{33}}{1 - r_{33} S_{33}^m} \qquad (7)$$

$$S_{23} = S_{23}^m - S_{13}^m S_{21}^m \frac{r_{11}}{1 - r_{11} S_{11}^m} \qquad (8)$$

$$S_{31} = S_{31}^m - S_{32}^m S_{21}^m \frac{r_{22}}{1 - r_{22} S_{22}^m} \qquad (9)$$

$$S_{32} = S_{32}^m - S_{31}^m S_{12}^m \frac{r_{11}}{1 - r_{11} S_{11}^m} \qquad (10)$$

Ebenso können auch die Gleichungen für ein n-Tor bestimmt werden, wobei sich Termine höherer Ordnung ergeben, die zwei und mehr $r_{ii}$-Werte enthalten. Diese können jedoch in guter Näherung vernachlässigt werden, da die $r_{ii}$-Werte klein sind, so daß jede Korrekturrechnung in Gestalt der unter Gleichung (2) gegebenen Lösung ist. Zum Beispiel gilt dann für ein 4-Tor:

$$S_{11} = S_{11}^m - S_{13}^m S_{31}^m \frac{r_{33}}{1 - r_{33} S_{33}^m} - S_{12}^m S_{21}^m \frac{r_{22}}{1 - r_{22} S_{22}^m} \qquad (11)$$

Im folgenden soll nun noch dargestellt werden, wie anhand der ermittelten Streuparameterwerte eines Dreitors die Multimodewerte eines Zweitors, das einen unsymmetrischen Eingang sowie ein Zweileitersystem, bei dem ein Gleich- und Gegentaktmode auftritt, umfaßt, erhalten werden können. Das Zweitor mit unsymmetrischem Eingang kann dabei z.B. eine Mikrostreifenleitung sein und das Zweileitersystem z.B. zwei parallele Mikrostreifenleitungen.

Dieses Verfahren ist insbesondere für SAW-Filter und Symmetrieglieder sehr interessant, da hier im Gegensatz zu den bekannten Verfahren die Verlustmechanismen separiert werden.

Das unsymmetrische Tor sei in Figur 8 das Tor 1 mit der hineinlaufenden Welle $a_1$ und der herauslaufenden Welle $b_1$. Die beiden anderen Tore für das Zweileitersystem seien die Tore 2 und 3 mit den Wellengrößen $a_2, a_3, b_2, b_3$. Die de-embeddeten Streuparameter für die drei Tore sind gegeben.

An dem Zweileitersystem tritt eine Gleich- und eine Gegentaktwelle auf, die sich mit den Größen $a_2^+, a_2^-, b_2^+, b_2^-$ beschreiben lassen. Der Schlüssel für die Multimoderechnung ist nun, daß sich in einem linearen System der Mode des unsymmetrischen Meßsystems mit den Moden des Zweileitersystems verknüpfen läßt:

$$a_2^+ = \frac{1}{\sqrt{2}}\left(a_2 + a_3\right) \qquad\qquad (12)$$

$$a_2^- = \frac{1}{\sqrt{2}}\left(a_2 - a_3\right) \qquad\qquad (13)$$

$$b_2^+ = \frac{1}{\sqrt{2}}\left(b_2 + b_3\right) \qquad\qquad (14)$$

$$b_2^- = \frac{1}{\sqrt{2}}\left(b_2 - b_3\right) \qquad\qquad (15)$$

Wertet man diese Gleichungen aus und definiert neue Streuparameter aus der üblichen Topologie mit den Wellengrößen a und b, aber mit den Modeberücksichtigungen, wobei eine 0 den unsymmetrischen Mode kennzeichnen soll, dann ergeben sich folgende neun Streuparameter für das Zweitor mit dem unsymmetrischen Eingang und dem symmetrischen Ausgang:

Eigenparameter für den unsymmetrischen Mode:

$$S_{11} = S_{11} \qquad\qquad (16)$$

Eigenparameter für den Gleichtaktmode:

$$S_{22}^+ = \frac{1}{2}\left(S_{22} + S_{23} + S_{32} + S_{33}\right) \qquad\qquad (17)$$

Eigenparameter für den Gegentaktmode:

$$S_{22}^- = \frac{1}{2}\left(S_{22} - S_{23} - S_{32} + S_{33}\right) \qquad\qquad (18)$$

Konversionsparameter für den Gleichtaktmode in den unsymmetrischen Mode:

$$S_{12}^{+0} = \frac{1}{\sqrt{2}}\left(S_{12} + S_{13}\right) \qquad (19)$$

Konversionsparameter für den Gegentaktmode in den unsymmetrischen Mode:

$$S_{12}^{-0} = \frac{1}{\sqrt{2}}\left(S_{12} - S_{13}\right) \qquad (20)$$

Konversionsparameter für den unsymmetrischen Mode in den Gleichtaktmode:

$$S_{21}^{0+} = \frac{1}{\sqrt{2}}\left(S_{21} + S_{31}\right) \qquad (21)$$

Konversionsparameter für den unsymmetrischen Mode in den Gegentaktmode:

$$S_{21}^{0-} = \frac{1}{\sqrt{2}}\left(S_{21} - S_{31}\right) \qquad (22)$$

Konversionsparameter für den Gleichtaktmode in den Gegentaktmode:

$$S_{22}^{+-} = \frac{1}{2}\left(S_{22} + S_{23} - S_{32} - S_{33}\right) \qquad (23)$$

Konversionsparameter für den Gegentaktmode in den Gleichtaktmode:

$$S_{22}^{-+} = \frac{1}{2}\left(S_{22} - S_{23} + S_{32} - S_{33}\right) \qquad (24)$$

Auch wenn die soeben näher ausgeführte Beschreibung eines Meßobjekts mit unsymmetrischen Moden durch separate Streuparameter für den Gleich- und den Gegentaktmode hier auf den erfindungsgemäß korrigierten Streuparametern beruht, so ist auch eine Verwendung dieser oder einer entsprechenden Beschreibung basierend auf anders ermittelten Streuparametern möglich.

**Patentansprüche**

**1.** Verfahren zur Fehlerkorrektur durch De-embedding von mit einem n Messtore (11) umfassenden, vektoriellen Netzwerkanalysator gemessenen Streuparametern eines mit den Messtoren (11) verbundenen Messobjekts, wobei das Verfahren die folgenden Schritte aufweist:

- Durchführung von bis zu $k = n \cdot \dfrac{}{2}$ Zweitor-Kalibrierungen mit verschiedenen, an die Messtore (11) im aktiven Zustand in beliebiger Reihenfolge geschalteten Kalibrierstandards als Grundlage für eine erste Fehlerkorrektur von gemessenen Streuparametern des Messobjekts, und

- Bestimmung der Reflexionsparameter zumindest einiger der n sich im inaktiven Zustand befindenden Messtore (11) anhand von Ergebnissen von Zweitor-Messungen an mindestens einem an Messtore (11) geschalteten Kalibrierstandard als Grundlage für eine zweite Fehlerkorrektur zumindest eines Teils von gemessenen und mit der ersten Fehlerkorrektur korrigierten Streuparametern des Messobjekts, wobei sich für die Zweitor-Messungen bei lediglich 3 oder 4 am Netzwerkanalysator angeordneten Messstellen ein senderseitiges Messtor im aktiven und ein empfängerseitiges Messtor im inaktiven Zustand und bei 2*n oder n+1, für n > 3 am Netzwerkanalysator angeordneten Messstellen beide Messtore (11) im aktiven Zustand befinden.

2. Verfahren nach Anspruch 1,
**dadurch gekennzeichnet, dass**
die Bestimmung der Reflexionsparameter mehrerer der n Messtore (11) welche sich im inaktiven Zustand befinden, anhand von sich bei der Durchführung der bis zu k Zweitor-Kalibrierungen für die erste Fehlerkorrektur ergebenden Messschritten erfolgt.

3. Verfahren nach Anspruch 1 oder 2,
**dadurch gekennzeichnet, dass**
die Reflexionsparameter aller von den n Messtoren (11) welche sich im inaktiven Zustand befinden, bestimmt werden.

4. Verfahren nach einem der Ansprüche 1 bis 3,
**dadurch gekennzeichnet, dass**
in einem weiteren Schritt die Streuparameter eines zu vermessenden Messobjekts bestimmt werden, diese Streuparameter einer ersten Fehlerkorrektur auf Grundlage der bis zu k Zweitor-Kalibrierungen unterzogen werden und die derart korrigierten Streuparameter zumindest teilweise einer zweiten Fehlerkorrektur auf Grundlage der bestimmten Reflexionsparameter von im inaktiven Zustand befindlichen Messtoren (11) unterzogen werden.

5. Verfahren nach einem der Ansprüche 1 bis 4, bei dem der Netzwerkanalysator, welcher die Kalibrier-messung an den Kalibrierstandards vornimmt, mindestens drei mit den Messtoren verbundene oder verbindbare Messstellen aufweist und bei dem im Einsatz mit vorhandenen koaxialen oder planaren Kalibrierstandards für die Zweitor-Kalibrierungen als Grundlage für die erste Fehlerkorrektur

- erste bis zu k Kalibriermessungen an jeweils einem Zweitor, das mittels der direkten Verbindung von zwei Messtoren oder mittels einer kurzen angepaßten Leitung bekannter Länge und Dämpfung, welche jeweils zwischen einer der k möglichen Messtorkombinationen angeschlossen wird, realisiert wird, durchgeführt werden,
- eine weitere Kalibriermessung an einem n-fachen Eintor, das entweder ein n Tor bestehend aus n Eintoren oder ein Eintor, welches an jedem der n Messtore angeschlossen und vermessen wird, umfasst und mittels zumindest einer bekannten Impedanz realisiert wird, durchgeführt wird,
- eine weitere Kalibriermessung an einem n-fachen Eintor, das entweder ein n Tor bestehend aus n Eintoren oder ein Eintor, welches an jedem der n Messtore angeschlossen und vermessen wird, umfasst und mittels zumindest einem Kurzschlüss realisiert wird, durchgeführt wird, und
- eine weitere Kalibriermessung an einem n-fachen Eintor, das entweder ein n Tor bestehend aus n Eintoren oder ein Eintor, welches an jedem der n Messtore angeschlossen und vermessen wird, umfasst und mittels zumindest einer Leerläuf realisiert wird, durchgeführt wird,

wobei der Wert des Parameters n jeweils gleich der Anzahl n der Messtore ist.

6. Verfahren nach einem der Ansprüche 1 bis 4, bei dem der Netzwerkanalysator für die Vermessung der Kalibrierstandards mindestens vier mit den Messtoren verbundene oder verbindbare Messstellen aufweist und bei dem im Einsatz mit vorhandenen koaxialen oder planaren Kalibrierstandards als Grundlage für die erste Fehlerkorrektur

- die Kalibrierstandards sämtlicher bekannter 7-Term-Verfahren zwischen den Messtoren in allen k möglichen Kombinationen in beliebiger Reihenfolge vermessen werden.

7. Verfahren nach einem der Ansprüche 1 bis 4, bei dem der Netzwerkanalysator für die Vermessung der Kalibrierstandards mindestens vier mit den Messtoren verbundene oder verbindbare Messstellen aufweist und bei dem im Einsatz mit vorhandenen koaxialen oder planaren Kalibrierstandards als Grundlage für die erste Fehlerkorrektur

- erste bis zu k Kalibriermessungen an jeweils einem Zweitor, das mittels der direkten Verbindung der Messtore oder mittels einer kurzen angepaßten Leitung bekannter Länge und bekannter Transmissionseigenschaften, die zwischen den k möglichen Messtorkombinationen angeschlossen wird, realisiert wird, durchgeführt werden,
- weitere Kalibriermessüngen an jeweils einem Zweitor, das mittels einer kurzen angepaßten Leitung unbekannter Länge und mit unbekannten Transmissionseigenschaften realisiert wird, durchgeführt werden, wobei die Leitung zwischen den möglichen k Messtorkombinationen angeschlossen wird, und
- eine weitere Kalibriermessung an einem n-Eintor, das mittels n Kurzschlüsse oder Leerläufe realisiert wird, durchgeführt wird, wobei der Wert des Parameters n jeweils gleich der Anzahl n der Messtore ist.

8. Verfahren nach einem der Ansprüche 1 bis 4, bei dem der Netzwerkanalysator für die Vermessung der Kalibrierstandards mindestens vier mit den Messtoren verbundene oder verbindbare Messstellen aufweist und bei dem im Einsatz mit vorhandenen koaxialen oder planaren Kalibrierstandards als Grundlage für die erste Fehlerkorrektur

- die bis zu k Kalibriermessungen an jeweils einem Zweitor, das mittels der direkten Verbindung der Messtore oder einer kurzen angepaßten Leitung bekannter Länge und bekannter Transmissionseigenschaften, die zwischen den k möglichen Messtorkombinationen angeschlossen wird, realisiert wird, durchgeführt werden,
- eine weitere Kalibriermessung an einem n-fachen Eintor, das mittels n bekannter Impedanzen realisiert wird, durchgeführt wird, und
- eine weitere Kalibriermessung an einem n-fachen Eintor, das mittels n Kurzschlüsse oder Leerläufe realisiert wird, durchgeführt wird,

wobei der Wert des Parameters n jeweils gleich der Anzahl n der Messtore ist.

9. Verfahren nach einem der voranstehenden Ansprüche im Einsatz mit bekannten koaxialen oder planaren Kalibrierstandards, das die Schritte umfaßt:

- Messen der Streuparameter eines mit drei Messtoren des Netzwerkanalysators verbundenen Messobjektes mit Gleichtaht-Moden und Gegentakt-

- Korrigieren der gemessenen Streuparameter mit einer ersten Fehlerkorrektur auf Grundlage der bis zu

$$k = n \cdot \frac{n-1}{7} = 3 \cdot \frac{3-1}{2} = 3$$ Zweitor-Kalibrierungen und einer zweiten Fehlerkorrektur auf Grundlage der bestimmten Reflexionsparameter, resultierend in zweifach korrigierten Streuparametern $S_{ij}$, mit i,j = 1 bis 3, wobei der jeweils zweite Index das Messtor identifiziert, über welches eine jeweilige Welle in das Messobjekt eingespeist wird, und der jeweils erste Index das Messtor identifiziert, über welches die jeweilige Welle das Messobjekt wieder verlässt, und
- Bestimmen von separaten Streuparametern für den Gleich- und den Gegentaktmode des Messobjekts aus den gemessenen und zweifach korrigierten Streuparametern $S_{22}$, $S_{23}$, $S_{32}$ und $S_{33}$, wobei für einen an beliebige Messtore i und j angeschlossenen symmetrischen Ausgang des Messobjekts die Eigenparameter für den Gleichtaktmode bestimmt werden zu $\frac{1}{2}\left(S_{22} + S_{23} + S_{32} + S_{33}\right)$, die Eigenparameter für den Gegentaktmode bestimmt werden zu $\frac{1}{2}\left(S_{22} - S_{23} - S_{32} + S_{33}\right)$, die Konversionsparameter für den Gleichtaktmode in den Gegentaktmode bestimmt werden zu $\frac{1}{2}\left(S_{22} + S_{23} - S_{32} - S_{33}\right)$ und die Konversionsparameter für den Gegentaktmode in den Gleichtaktmode bestimmt werden zu $\frac{1}{2}\left(S_{22} - S_{23} + S_{32} - S_{33}\right)$ .

## Claims

1. Process for error correction by de-embedding of scattering parameters, measured with a vectorial network analyser comprising n measuring ports (11), of an object of measurement which is connected to the measuring ports (11), the process having the following steps:

   - implementation of up to $k = n \cdot \dfrac{n-1}{2}$ two-port-network calibrations with various calibration standards which have been switched in arbitrary sequence to the measuring ports (11) in the active state as a base for a first error correction of measured scattering parameters of the object of measurement, and
   - determination of the reflection parameters of at least some of the n measuring ports (11) in the inactive state on the basis of results of two-port-network measurements in respect of at least one calibration standard which has been switched to measuring ports (11) as a base for a second error correction of at least some measured scattering parameters of the object of measurement which have been corrected with the first error correction, whereby for the two-port-network measurements in the case of only 3 or 4 measuring points arranged on the network analyser a transmitter-side measuring port is in the active state and a receiver-side measuring port is in the inactive state and in the case of 2n or n+1, for n > 3, measuring points arranged on the network analyser both measuring ports (11) are in the active state.

2. Process according to Claim 1,
   **characterised in that**
   the determination of the reflection parameters of several of the n measuring ports (11) which are in the inactive state is effected on the basis of measuring steps resulting in the course of the implementation of the up to k two-port-network calibrations for the first error correction.

3. Process according to Claim 1 or 2,
   **characterised in that**
   the reflection parameters of all of the n measuring ports (11) that are in the inactive state are determined.

4. Process according to one of Claims 1 to 3,
   **characterised in that**
   in a further step the scattering parameters of an object of measurement to be gauged are determined, these scattering parameters are subjected to a first error correction on the basis of the up to k two-port-network calibrations, and the scattering parameters corrected in such a manner are at least partially subjected to a second error correction on the basis of the determined reflection parameters of measuring ports (11) in the inactive state.

5. Process according to one of Claims 1 to 4, wherein the network analyser which performs the calibration measurement in respect of the calibration standards has at least three measuring points which are connected or connectable to the measuring ports and wherein in operation with available coaxial or planar calibration standards for the two-port-network calibrations as a basis for the first error correction

   - first, up to k, calibration measurements are implemented in respect of, in each case, a two-port network which is realised by means of the direct connection of two measuring ports or by means of a short adapted line of known length and attenuation, which in each case is connected between one of the k possible measuring-port combinations,
   - a further calibration measurement is implemented in respect of an n-fold one-port network which comprises either an n port network, consisting of n one-port networks, or a one-port network, which is connected to each of the n measuring ports and gauged, and is realised by means of at least one known impedance,
   - a further calibration measurement is implemented in respect of an n-fold one-port network which comprises either an n port network, consisting of n one-port networks, or a one-port network, which is connected to each of the n measuring ports and gauged, and is realised by means of at least one short circuit, and
   - a further calibration measurement is implemented in respect of an n-fold one-port network which comprises either an n port network, consisting of n one-port networks, or a one-port network, which is connected to each of the n measuring ports and gauged, and is realised by means of at least one open-circuit operation,

the value of the parameter n being in each case equal to the number n of measuring ports.

6. Process according to one of Claims 1 to 4, wherein the network analyser for the gauging of the calibration standards has at least four measuring points which are connected or connectable to the measuring ports, and wherein in operation with available coaxial or planar calibration standards as a basis for the first error correction,

   - the calibration standards of all the known 7-term processes are gauged in arbitrary sequence between the measuring ports in all k possible combinations.

7. Process according to one of Claims 1 to 4, wherein the network analyser for the gauging of the calibration standards has at least four measuring points which are connected or connectable to the measuring ports and wherein in operation with available coaxial or planar calibration standards as a basis for the first error correction,

   - first, up to k, calibration measurements are implemented in respect of, in each case, a two-port network which is realised by means of the direct connection of the measuring ports or by means of a short adapted line of known length and known transmission properties which is connected between the k possible measuring-port combinations,
   - further calibration measurements are implemented in respect of, in each case, a two-port network which is realised by means of a short adapted line of unknown length and with unknown transmission properties, the line being connected between the k possible measuring-port combinations, and
   - a further calibration measurement is implemented in respect of an n-fold one-port network which is realised by means of n short circuits or open-circuit operations, the value of the parameter n being in each case equal to the number n of measuring ports.

8. Process according to one of Claims 1 to 4, wherein the network analyser for the gauging of the calibration standards has at least four measuring points which are connected or connectable to the measuring ports, and wherein in operation with available coaxial or planar calibration standards as a basis for a first error correction,

   - the up to k calibration measurements are implemented in respect of, in each case, a two-port network which is realised by means of the direct connection of the measuring ports or a short adapted line of known length and known transmission properties, which is connected between the k possible measuring-port combinations,
   - a further calibration measurement is implemented in respect of an n-fold one-port network which is realised by means of n known impedances, and
   - a further calibration measurement is implemented in respect of an n-fold one-port network which is realised by means of n short circuits or open-circuit operations,

the value of the parameter n being in each case equal to the number n of measuring ports.

9. Process according to one of the foregoing claims in operation with known coaxial or planar calibration standards, which encompasses the following steps:

   - measuring the scattering parameters of an object of measurement which is connected to three measuring ports of the network analyser with common modes and push-pull modes,

   - correcting the measured scattering parameters with a first error correction on the basis of the up to

   $$k = n \cdot \frac{n-1}{7} = 3 \cdot \frac{3-1}{2} = 3 \text{ two-port-network calibrations and a second error correction}$$

   on the basis of the determined reflection parameters, resulting in twice-corrected scattering parameters $S_{ij}$, with i,j - 1 to 3, the second index in the given case identifying the measuring port via which a respective wave is fed into the object of measurement, and the first index in the given case identifying the measuring port via which the respective wave leaves the object of measurement again, and
   - determining separate scattering parameters for the common mode and the push-pull mode of the object of measurement from the measured and twice-corrected scattering parameters $S_{22}$, $S_{23}$, $S_{32}$ and $S_{33}$, whereby for a symmetrical output of the object of measurement connected to arbitrary measuring ports i and j the intrinsic parameters for the common mode are determined as $\frac{1}{2}(S_{22} + S_{23} + S_{32} + S_{33})$, , the intrinsic parameters for the push-pull mode are determined as $\frac{1}{2}(S_{22} - S_{23} - S_{32} + S_{33})$, the parameters for conversion from the common mode into the push-pull mode are determined as $\frac{1}{2}(S_{22} + S_{23} - S_{32} - S_{33})$, and the parameters for conversion from the push-pull mode into the common mode are determined as $\frac{1}{2}(S_{22} - S_{23} + S_{32} - S_{33})$.

## Revendications

1. Procédé de correction d'erreurs par retrait d'enrobage d'objets de mesure liés à des portes de mesure (11) ayant des paramètres de dispersion mesurés par des analyseurs réseau vectoriels comprenant les portes de mesure (11), le procédé comprenant les étapes suivantes :

   - réaliser jusqu'à $k = n \cdot \frac{n-1}{2}$ calibrages biportes avec différentes références de calibrage connectées différentes dans un ordre préféré au niveau des portes de mesure (11) dans un état actif en tant que base pour une première correction d'erreurs de paramètres de dispersion mesurés de l'objet de mesure, et
   - déterminer le paramètre de réflexion d'au moins l'une des n portes de mesure (11) se trouvant dans un état inactif en s'appuyant sur des résultats de mesures de réseau biportes au niveau d'au moins une référence de calibrage connectée aux portes de mesure (11) en tant que base pour une seconde correction d'erreurs d'au moins une partie des paramètres de dispersion mesurés et corrigés avec la première correction d'erreurs de l'objet de mesure, seulement 3 ou 4 points de mesure disposés au niveau de l'analyseur réseau se trouvant au niveau d'une porte de mesure côté émetteur dans un état actif et d'une porte de mesure côté récepteur dans un état inactif pour les mesures biportes et 2*n ou n+1, pour n>3, points de mesure disposés au niveau de l'analyseur réseau des deux portes de mesure (11) se trouvant dans un état actif.

2. Procédé selon la revendication 1, **caractérisé en ce que**, la détermination des paramètres de réflexion s'effectue au niveau de plusieurs des n portes de mesure (11), lesquelles se trouvent dans un état inactif, en s'appuyant sur la réalisation des jusqu'à k calibrages biportes pour les étapes de mesure produisant la première correction d'erreurs.

3. Procédé selon la revendication 1 ou 2, **caractérisé en ce que**, les paramètres de réflexion de toutes les n portes de mesure (11), lesquelles se trouvent dans un état inactif, peuvent être déterminés.

4. Procédé selon l'une quelconque des revendications 1 à 3, **caractérisé en ce que**, dans une étape ultérieure, les paramètres de dispersion d'un objet de mesure à mesurer peuvent être déterminés, ces paramètres de dispersion pouvant être soumis à une première correction d'erreurs sur la base des jusqu'à k calibrages biportes et les paramètres de dispersion corrigés de cette manière pouvant au moins être soumis en partie à une seconde correction d'erreurs sur la base des paramètres de réflexion déterminés des portes de mesure (11) se trouvant dans un état inactif.

5. Procédé selon l'une quelconque des revendications 1 à 4, par lequel l'analyseur réseau, lequel effectue la mesure de calibrage au niveau de la référence de calibrage, présente au moins trois points de mesure reliés ou pouvant être reliés aux portes de mesure et par lequel, lors de la mise en oeuvre avec les références de calibrage coaxiales ou planaires présentes pour les calibrages biportes peut réaliser comme base pour la première correction d'erreurs:

   - la première à la kième mesure de calibrage chaque fois au niveau d'une biporte, ceci à l'aide de la liaison directe de deux portes de mesure ou à l'aide d'une ligne électrique adaptée courte ayant une longueur et une atténuation connues, laquelle est connectée entre l'une des k combinaisons de portes de mesure possibles,
- une mesure de calibrage supplémentaire au niveau d'une des n monoportes, laquelle comprend soit n portes constituées de n monoportes soit une monoporte, laquelle est connectée et mesurée au niveau de chacune des n portes de mesure et réalisée à l'aide d'au moins une impédance connue,
- une mesure de calibrage supplémentaire au niveau d'une des n monoportes, laquelle comprend soit n portes constituées de n monoportes soit une monoporte, laquelle est connectée et mesurée au niveau de chacune des n portes de mesure et réalisée à l'aide d'au moins un court-circuit, et
- une mesure de calibrage supplémentaire au niveau d'une des n monoportes, laquelle comprend soit n portes constituées de n monoportes soit une monoporte, laquelle est connectée et mesurée au niveau de chacune des n portes de mesure et réalisée à l'aide d'au moins un fonctionnement à vide,

la valeur du paramètre n étant à chaque fois égale au nombre n des portes de mesure.

6. Procédé selon l'une quelconque des revendications 1 à 4, par lequel l'analyseur réseau présente au moins quatre points de mesure reliés ou pouvant être reliés avec les portes de mesure pour la mesure des références de calibrage, et par lequel, lors de la mise en oeuvre avec les références de calibrage coaxiales ou planaires présentes en tant que base pour la première correction d'erreurs peut réaliser

- la mesure des références de calibrage de tous les procédés à 7 termes connus entre les portes de mesure dans toutes les k combinaisons possibles dans l'ordre souhaité.

7. Procédé selon l'une quelconque des revendications 1 à 4, par lequel l'analyseur réseau présente au moins quatre points de mesure reliés ou pouvant être reliés avec les portes de mesure pour la mesure des références de calibrage, et par lequel, lors de la mise en oeuvre avec les références de calibrage coaxiales ou planaires présentes peut réaliser en tant que base pour la première correction d'erreurs:

- la première à la kième mesure de calibrage chaque fois au niveau d'une biporte, ceci à l'aide de la liaison directe des portes de mesure ou à l'aide d'une ligne électrique adaptée courte ayant une longueur et des propriétés de transmission connues, laquelle est connectée entre les k combinaisons de portes de mesure possibles,
- des mesures de calibrage supplémentaires à chaque fois au niveau d'une biporte, à l'aide d'une ligne électrique adaptée courte de longueur connue et ayant des propriétés de transmission inconnues, la ligne électrique étant connectée entre les k combinaisons de portes de mesure possibles, et
- une mesure de calibrage supplémentaire au niveau d'une n monoporte, laquelle est réalisée à l'aide de n courts-circuits ou d'un fonctionnement à vide,

la valeur du paramètre n étant à chaque fois égale au nombre n des portes de mesure.

8. Procédé selon l'une quelconque des revendications 1 à 4, par lequel l'analyseur réseau présente au moins quatre points de mesure reliés ou pouvant être reliés avec les portes de mesure pour la mesure des références de calibrage, et par lequel, lors de la mise en oeuvre avec les références de calibrage coaxiales ou planaires présentes peut réaliser en tant que base pour la première correction d'erreurs:

- jusqu'à la kième mesure de calibrage chaque fois au niveau d'une biporte, ceci à l'aide de la liaison directe des portes de mesure ou à l'aide d'une ligne électrique adaptée courte ayant une longueur connue et des propriétés de transmission connues, laquelle est connectée entre les k combinaisons de portes de mesure possibles,
- une mesure de calibrage supplémentaire au niveau d'une des n monoportes, ceci à l'aide de n impédances connues, et
- une mesure de calibrage supplémentaire au niveau d'une des n monoportes, ceci à l'aide de n courts-circuits ou fonctionnement à vide,

la valeur du paramètre n étant à chaque fois égale au nombre n des portes de mesure.

9. Procédé selon l'une quelconque des revendications précédentes, pour la mise en oeuvre de références de calibrage coaxiales ou planaires connues, comprenant les étapes suivantes :

- mesurer les paramètres de dispersion d'un objet de mesure relié par trois portes de mesure de l'analyseur réseau avec des modes de synchronisation et des modes d'asynchronisation,

- corriger les paramètres de mesure mesurés avec une première correction d'erreurs sur la base des jusqu'à

$$k \; = \; n \cdot \frac{n-1}{7} = 3 \cdot \frac{3-1}{2} = 3$$ calibrages biportes et d'une seconde correction d'erreurs sur la base des paramètres de réflexion déterminés, aboutissant à des paramètres de dispersion corrigés deux fois $S_{ij}$, avec i, j = 1 à 3, le second indice identifiant la porte de mesure par laquelle une onde est délivrée dans l'objet de mesure, et le premier indice identifiant la porte de mesure par laquelle l'onde sort de l'objet de mesure, et
- déterminer les paramètres de dispersion séparés pour les modes de synchronisation et d'asynchronisation de l'objet de mesure à partir des paramètres de dispersion mesurés et corrigés deux fois $S_{22}$, $S_{23}$, $S_{32}$ et $S_{33}$, les paramètres propres pour le mode de synchronisation pour un côté basse tension symétrique connecté aux portes de mesure i et j préférées de l'objet de mesure pouvant être déterminés par

$$\frac{1}{2}(S_{22} + S_{23} + S_{32} + S_{33}),$$ les paramètres propres pour le mode d'asynchronisation pouvant être déterminés par $$\frac{1}{2}(S_{22} - S_{23} - S_{32} + S_{33}),$$ les paramètres de conversion pour le mode de synchronisation dans le mode d'asynchronisation pouvant être déterminés par $$\frac{1}{2}(S_{22} + S_{23} - S_{32} - S_{33})$$ et les paramètres de conversion pour le mode d'asynchronisation dans le mode de synchronisation pouvant être déterminés par

$$\frac{1}{2}(S_{22} - S_{23} + S_{32} - S_{33}).$$

Fig.1

Fig.2

Fig.3

Fig.4

Fig.5

Fig.6

Fig.7

22    R    A    15    15    B    22

18

24

Äußeres Tor 1    Äußeres Tor 2

19

11    10    11

25    20    20    25

EP 1 421 400 B1

25

Fig.8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19918697 A1
- DE 19918960 A1